# EUROPEAN PATENT SPECIFICATION

(11) **EP 3 543 371 B1**
(45) Date of publication and mention of the grant of the patent: **06.01.2021**
(21) Application number: 18174491.3
(22) Date of filing: 28.05.2018
(51) Int. Cl.: C23C 14/04, C23C 14/28, H05K 3/14, G03F 7/20, B23K 26/08, B23K 26/082, B23K 26/34, B23K 26/57

(54) **CONTINUOUS LASER INDUCED FORWARD TRANSFER OF MATERIAL SYSTEM**
KONTINUIERLICHE LASERINDUZIERTE VORWÄRTSÜBERTRAGUNG EINES MATERIALSYSTEMS
SYSTÈME DE TRANSFERT AVANT DE MATÉRIAUX INDUIT PAR LASER CONTINU

(30) Priority: 22.03.2018 EP 18382193
(43) Date of publication of application: 25.09.2019
(73) Proprietor: Fundación I + D Automoción y Mecatrónica, 31110 Noain (Navarra) (ES)
(72) Inventor: VARELA LÓPEZ, Fernando, 31110 NOAIN (Navarra) (ES); CORNAGO SANTOS, Iñaki, 31110 NOAIN (Navarra) (ES); MORENTIN LARRAONA, Javier, 31110 NOAIN (Navarra) (ES)
(74) Representative: Ungria López, Javier

(56) References cited:
- US-A1- 2011 097 550
- US-A1- 2016 233 089
- US-A1- 2018 015 671

## Description

### OBJECT OF THE INVENTION

The following invention relates to a system for continuous laser-induced forward transfer of material comprising a continuous conveyor belt, as a donor substrate, driven in a closed circuit located between two supports, where one of the faces of the conveyor belt is a depositing face on which, on a certain application area of the closed circuit, the donor material to be transferred is deposited by means of deposition or printing through the application of laser radiation by means of a laser head on a receiver substrate, making it so that, by means of a system of shafts, the deposition face stays directly facing the receiving substrate and the closed circuit stays configured in a U-shape where the laser head has a wide area to position itself.

An important advantage of the system object of the invention is the configuration of the system, which enables that the area intended for the transfer of the donor material stays completely free, enabling the use of laser heads with long focal length which, by being able to stay as far from the donor substrate as necessary, enables a large actuation surface to be had.

### BACKGROUND OF THE INVENTION

As is known, *laser-induced forward transfer (LIFT)* systems are based on the deposition of material to be deposited or printed onto a donor substrate, transparent to a certain laser radiation, such that the donor substrate stays facing a receiving substrate onto which it will be deposited or printed, by means of a laser radiation focused on the interface of donor material and donor substrate, with which interaction the material to be deposited or printed is transferred to the receiving substrate.

Thus, we can consider different patent files, and thus in document EP2955981 a method for manufacturing selective surface deposition using a pulsed radiation treatment, further providing a method of direct surface metallization of various types of receiving materials.

Document US 2015140229 describes a method for deposition of a material onto a target substrate through a burst of ultrafast laser pulses of a laser beam through a carrier substrate that is transparent to the laser radiation, while document US2017189995 describes a method for material deposition which includes a donor substrate, transparent to the laser radiation, with a donor film close to a receiving substrate, in an atmosphere containing oxygen, such that by means of pulses of laser radiation an outer layer comprising a metal oxide is formed on the receiving substrate.

Document US2017246882 describes a method and apparatus for transferring a printing substance provided as a coating on a carrier by laser radiation from a laser source that comprises an amplifier.

Document WO2016063270 describes a method for metallization that comprises a transparent donor substrate that has a donor film that includes a metal with a thickness of less than 2 µm, placing the donor substrate close to a receiving substrate that includes a semiconductor material with a gap between them of, at least, 0.1 mm, such that by means of a train of laser pulses, the metal of the donor substrate is ejected towards the receiving substrate forming a circuit trace in ohmic contact with the semiconductor material.

Document US2018/015671 discloses a system for continuous laser induced forward transfer of material, which includes most of the features of the preamble of claim 1.

Finally, document WO2016020817 describes a printing apparatus that includes a donor supply assembly which provides a transparent donor substrate, which is positioned in proximity to a target area on a receiving substrate, such that an optical assembly directs multiple output beams of laser radiation in a predefined pattern.

### DESCRIPTION OF THE INVENTION

A system for continuous laser-induced forward transfer of material according to the invention is defined in the appended claims.

The present specification describes a system for continuous laser-induced forward transfer of material, where the material to be transferred, deposited onto a donor substrate, transparent to the laser radiation, is transferred to a receiving substrate by laser radiation focused on the interface between the material to be transferred and the donor substrate. The system comprises a conveyor belt, as a donor substrate, rotating in a closed circuit, where one of the faces is a deposition face, intended so that, in an application area of the closed circuit, the donor material to be transferred is deposited onto it. The material is deposited continuously and the application area, is preferably located either on the first shaft or on the second shaft.

In the system, the closed circuit by which the conveyor belt is driven is formed by a unitary block defined by a pair of supports facing each other.

The supports of the unitary block comprise:
∘ a first shaft and a second shaft located on opposite sides of the corresponding support and one of them being a drive shaft and the other a driven shaft;
∘ a first roller and a second roller arranged in a position lower than the first shaft of the first support and in the transversal direction, the two rollers being able to be located in one single shaft or each one in a different parallel shaft;
∘ a third roller and a fourth roller arranged in a position lower than the second shaft of the second support and in the transversal direction, the two rollers being able to likewise be located in a single shaft or each one in a different parallel shaft;

The first and second shafts can also incorporate rollers. It must be taken into account that all the rollers, except the roller incorporated into the drive shaft, can rotate freely with respect to the shaft in which they are located. Thus, there is a possibility that two rollers located in a same axis can rotate in different directions.

Thus, the conveyor belt runs sequentially along the first support around the first shaft, of the first roller, is directed to the second support to pass around the third roller, of the second shaft, the fourth roller, back to the first support around the second roller and ends in the first shaft, closing the conveyor belt. Thus, the unitary block is configured in a U shape for the location between the two supports of the laser head with a wide positioning area.

Furthermore, the conveyor belt rotates 90 degrees longitudinally in all the segments between the rollers and the first and second shafts, such that the deposition face is free of contact with the elements of the system.

Moreover, a material transfer area "A" is defined from the donor substrate to the receiving substrate that is located in the position of the conveyor belt between the third shaft and the fourth shaft.

Moreover, the first roller and the second roller can be located, both of them, in a third shaft and the third roller and the fourth roller can be located, both as well, in a fourth shaft.

Moreover, the first support can incorporate a fifth shaft so that the second roller may be located while the first roller can be located in the third shaft. Furthermore, the second support can incorporate a sixth shaft so that the fourth roller may be located while the second roller is located in the fourth shaft.

The system also comprises a laser head, positioned centered between the two supports and on the interface between the donor substrate and the donor material, above the receiving substrate (area 'A') and at a long distance from them, according to the focal distance of the lens used in the laser head.

The unitary block is positioned rotated an angle around the Z-axis, with respect to the linear scanning of the laser head, configured in the direction of the X-axis, the receiving substrate being configured to advance according to the Y-axis.

To complete the description provided below, and for the purpose of helping to make the characteristics of the invention more readily understandable, the present specification is accompanied by a set of figures which by way of illustration and not limitation represent the most characteristic details of the invention.

### BRIEF DESCRIPTION OF THE DRAWINGS

Figure 1. Shows a perspective view of the unitary block made up of a pair of supports facing each other in which the driving shafts are mounted with the corresponding rollers and the conveyor belt, as a donor substrate, which circulates through them, in a first embodiment.
Figure 2. Shows a perspective view of the unitary block with the shafts, the rollers and the conveyor belt, in a second embodiment.
Figure 3. Shows a front schematic view of the system object of the invention represented in figure 1, being able to see the transfer area "A" for the donor material.
Figure 4. Shows a widened view of a cross-sectional view according to B-B of the system, being able to see how the material deposition face of the conveyor belt is directly facing, parallel to and in proximity to the receiving substrate.
Figure 5. Shows a plan view in detail of the transfer area "A" for the donor material, being able to see how the conveyor belt, as a donor substrate, advances in an oblique manner forming an angle with respect to the scanning direction of the laser, X.

Below a list of the references used in the figures is facilitated:
1. conveyor belt as a donor substrate
2. deposition face for the donor material
3. application area
4. receiving substrate
5. unitary block
6. first support
7. second support
8. first shaft
9. second shaft
10. third shaft
11. first roller
12. second roller
13. fourth shaft
14. third roller
15. fourth roller
16. fifth shaft
17. sixth shaft
18. laser head
19. laser beam
20. linear scanning
21. angle of the unitary block with the laser scanning
X axis according to the direction of the laser scanning
Y axis according to the direction of the movement of the receiving substrate
Z axis perpendicular to the X and Y-axes

### DESCRIPTION OF A PREFERRED EMBODIMENT

As shown in the aforementioned figures and in accordance with the specified numbering it can be seen how the system for continuous laser-induced forward transfer of material is based on a conveyor belt 1, which is used as a donor substrate, which is transparent to the laser radiation and continuous, meaning that it is driven in a closed circuit that is extended between two supports 6, 7 which make up a unitary block 5. One of the faces of the conveyor belt 1 carries out the function of a deposition face 2 and onto it the donor material is deposited which will be transferred to a receiving substrate 4. The deposition of donor material is performed on an application area 3 of the closed driving circuit, such that, on an area "A" of the closed driving circuit of the conveyor belt the deposition face 2 is directly facing, parallel to and in proximity to the receiving substrate 4 so that, by means of the application of a linear scanning 20 from a laser head 18, the transfer of material is performed. The way in which the conveyor belt is positioned with respect to the receiving substrate 4 for performing the transfer will be described later on. Both the laser head 18 and the supports 6, 7 are fixed by external elements, being the relative positions of the three elements with each other and with respect to the receiving substrate 4 previously defined.

The system for forward transfer of material of the invention is made up of a unitary block 5 defined by a pair of supports 6 and 7, each one of the supports 6, 7 made up of, by way of example, by means of an inverted T-shaped plate with the folded arms perpendicular to the body. The supports 6, 7 are facing each other and are carriers of a series of shafts 8, 9, 10, 13, 16, 17 that define the closed driving circuit of the conveyor belt 1. Said supports 6 and 7 could be likewise defined by a profile with a U-shaped cross section or by any other equivalent configuration.

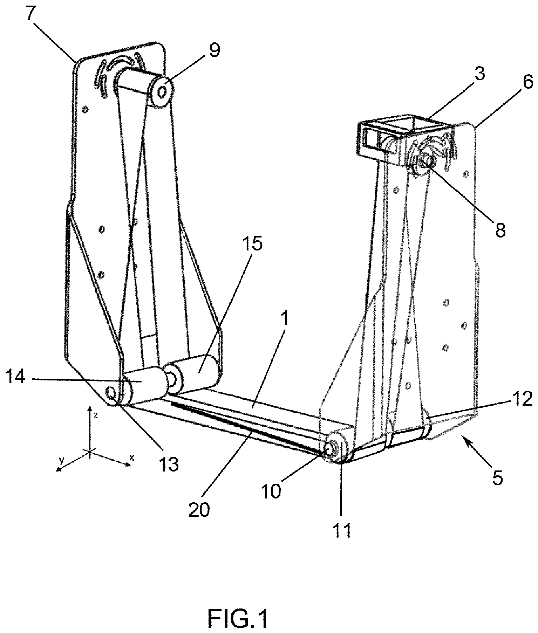

In a first embodiment, as shown in figure 1, the two supports 6,7 respectively incorporate a first shaft 8 and a second shaft 9 located perpendicularly in the upper portion of the respective supports 6, 7, which can be aligned or in parallel shafts. On the other end, located between the pair of arms and fixed to them, each support 6, 7 respectively incorporates a third shaft 10, with a pair of rollers 11, 12 and a fourth shaft 13 with a pair of rollers 14, 15. The third shaft 10 and fourth shaft 13 are fastened to the arms of the T, while the rollers 11, 12, 14, 15, are in fixed positions, having free rotation in the shafts 10, 13. Preferably, the third shaft 10 is in the same relative position, with respect to the arms of the corresponding support 6, 7, as the fourth shaft 13.

Thus, each support 6, 7 respectively comprises a shaft 8, 9 located perpendicularly on the free end of the body of the T and a shaft 10, 13 located between the arms of the T, perpendicular to the shaft 8, 9 of the end of the body of the T.

Thus, the closed circuit that the conveyor belt 1 follows is as represented in figure 1 and is described below.

Starting from the first support 6, the conveyor belt 1 surrounds the first shaft 8, falling tangentially by the surface thereof until it arrives at the surface of a roller 11 located in the third shaft 10 that, upon being oriented perpendicularly, must have rotated 90 degrees longitudinally. From the roller 11 of the third shaft 10, the belt is directed to the roller 14 of the fourth shaft 13, already in the second support 7. From here it is directed to the second shaft 9, for which it must have rotated 90 degrees longitudinally, just like between the first shaft 8 and the third shaft 10. From the second shaft 9, the belt is directed to the roller 15 located in the fourth shaft 13, rotating 90 degrees longitudinally again, in order to return to the first support 6 and be directed to the roller 12 located in the third shaft 10, closing the circuit in the first shaft 8, for which reason it will need to make a final longitudinal rotation of 90 degrees.

In order to reach a fluid movement and position of the conveyor belt, the rollers 11, 12, 14, 15 are located on the ends of the shafts 10, 13, together with the arms of the corresponding support 6, 7 while the first shaft 8 and the second shaft 9 are centered on the other end of the support 6, 7. For the same reason, both the first shaft 8 and the second shaft 9 can incorporate a roller.

Of all the shafts 8, 9, 10, 13 of the system, only one of them, to be selected from among the first shaft 8 and the second shaft 9, is a drive shaft. In this case, if the drive shaft incorporates a roller, it is integrally joined to it, such that it adequately transmits the movement, while if the shafts are not drive shafts, the rollers rotate freely. The energy is applied to the drive shaft by means of conventional means known in the state of the art.

In a preferred embodiment, the application area 3 for deposition of the donor material onto the deposition face 2 of the conveyor belt 1 is in correspondence with the first shaft 8, while the second shaft 9 is the drive shaft for driving the conveyor belt 1. The donor material, normally, is ink, although it can be any other material for any application.

Thus, with the mentioned configuration of the unitary block 5, the transfer area "A", by means of deposition or printing, of the donor material from the deposition face 2 is determined by the portion for driving the conveyor belt 1 located between the arms of the two supports 6, 7 that face each other. The receiving substrate 4 of the material is below this area, as indicated previously, and is directly facing, parallel to and in proximity to the deposition face 2 of the conveyor belt 1 so that, upon applying a linear scanning 20 from the laser head 18, the transfer of material is performed. The deposition face 2 of the conveyor belt 1 rotates longitudinally in order to be coupled in the corresponding rollers such that the deposition face 2 never comes into contact with rollers 11, 12, 14, 15 or with the shafts 8, 9. For the same reason, in the transfer area "A" the deposition face 2 is located towards the outside of the supports 6, 7 in order to receive the receiving substrate 4.

Thus, the system of the invention is made up by means of two supports 6, 7 which are linked by means of the conveyor belt 1 and integrally joined to an external fixing, not shown in the figures, located such that the transfer area "A" of the donor material is positioned in proximity on a receiving substrate 4 upon which the donor material is transferred from the deposition face 2 of the conveyor belt 1.

The laser head 18 by means of which the transmission of material is performed is integrally joined to an external fixing, not shown in the figures, and is arranged between the pair of supports 6 and 7 of the unitary block 5, preferably centered, in an elevated position with respect to the transfer area "A" of the donor material, focused in the interface between the donor substrate and the donor material, such that, upon the system being configured in U-shape, the space located between the pair of supports 6, 7 above the transfer area "A" stays free and the use of laser heads 18 with a long focal length, far from the transfer area "A" for the donor material, is enabled, it being possible to have large areas where the laser can actuate. This, together with the linear movement on the Y-axis of the receiving substrate 4, enables the transfer of the donor material to be performed on large areas, upon having a continuous feed of donor material.

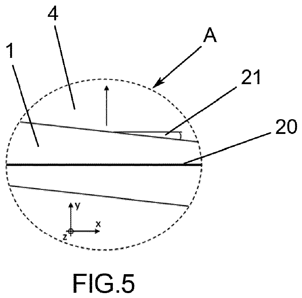

An important characteristic of the system is given by the fact that the unitary block 5 is rotated on the Z-axis the advance direction of the belt forming a small angle 21 with the X-axis (figure 5) and, given that the laser head 18 scans linearly, oriented according to the X-axis, it is achieved that the laser head 18, in the scanning thereof, always indicates areas equipped with "fresh" donor material, meaning, without having interacted previously with the laser.

Referring to the figures it is seen how figure 1 corresponds to the unitary block 5 made up of the pair of supports 6, 7 which assemble the different driving shafts/rollers of the conveyor belt 1 and incorporating a mortise for defining the application area 3 relative to the first shaft 8 of donor material 2.

Likewise, in said figure the first support 6 has been represented transparently with the aim of enabling the assembly of the conveyor belt 1 to be seen adequately.

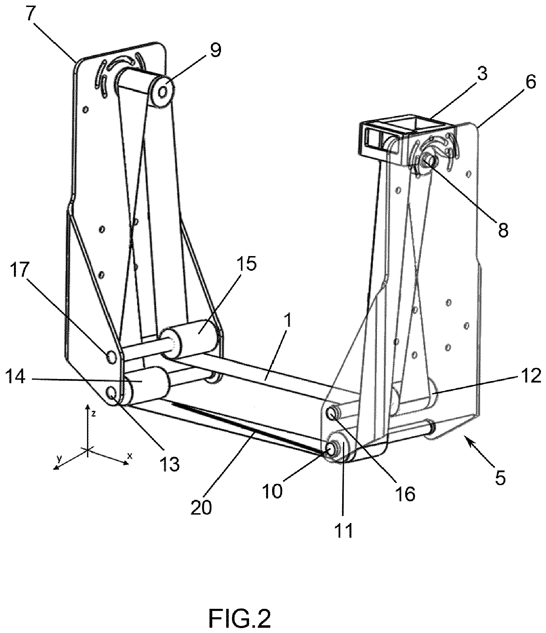

Figure 2 represents a second embodiment of the unitary block 5 in which instead of a using a single shaft 10, 13 with a pair of rollers 11-12, 14-15 between the arms of the supports 6, 7, the first support 6 uses the third shaft 10 with a single roller 11, the other roller 12 being located in a fifth shaft 16, parallel to the third shaft 10. Likewise, the second support 7 uses the fourth shaft 13 with a single roller 14, the other roller 15 being located in a sixth shaft 17, parallel to the fourth shaft 13. In this case, the roller of each shaft is located together with one of the arms of the T of the corresponding support, meaning, each roller on a side of the first or second shaft 8, 9, depending on the side by which it communicates with the shaft of the other end of the support 6, 7.

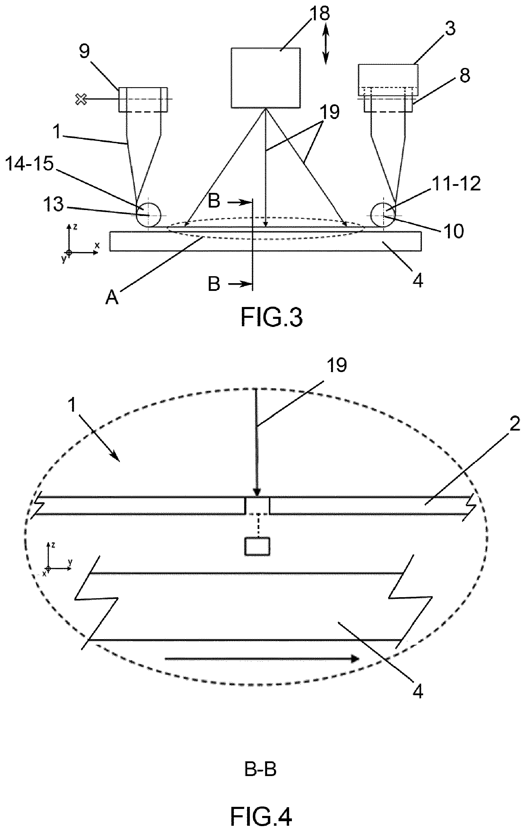

In figure 3 a front schematic view of the embodiment described in figure 1 is shown, how the laser head 18 is centered between the two supports 6, 7 and at the height relative to the focal distance thereof, while in the transfer area "A" of donor material, the conveyor belt 1 is, with the deposition face 2 of the donor material facing the receiving substrate 4 that advances in the direction of the Y-axis.

In figure 4 a detail view of the cross-section B-B marked in figure 3 is shown, showing the incidence of the laser beam 19 on the conveyor belt 1 causing the transfer of the donor material from the deposition face 2 to the receiving substrate 4, it being able to be seen how the receiving substrate 4 moves according to the Y-axis.

In figure 5 a detail plan view is seen of the representation of the linear scanning 20 of the laser head 18, according to the X-axis, marked on the conveyor belt 1, with the aim of clarifying the understanding thereof. The linear scanning 20 has an angle 21 with respect to the conveyor belt 1. Thus it allows for, by combining the advance of the conveyor belt 1 with the subsequent scanning 20 of the laser head 18, the scanning 20 over the donor substrate 1 to always be produced on an area equipped with donor material 2.

Likewise, the system is equipped with means that enable the conveyor belt 1 to be adequately tight. Thus, at least one of the shafts to be selected from among the first shaft 8 and the second shaft 9, can be moved perpendicularly to the other shafts located between the arms of the corresponding support 6, 7.

To conclude, the proposed system enables the carrying out of a continuous laser-induced forward transfer on large areas.

## Claims

1. **A system for continuous laser-induced forward transfer of material,** where the donor material to transfer, deposited onto a donor substrate, transparent to the laser radiation, is transferred to a receiving substrate (4) by means of a laser head (18) that emits a laser radiation focused on the interface between the donor material and the donor substrate in a transfer area "A", wherein the donor substrate is a continuous conveyor belt (1) with a deposition face (2) where the donor material is deposited and comprises:
- a mortise located in an application area (3) for the access to the conveyor belt (1), where the donor material is applied,
- a unitary block (5) defined by a pair of supports (6 and 7) facing each other, the first support (6) and the second support (7) respectively being carriers of:
- a first shaft (8) and a second shaft (9), aligned in one same axis or in parallel axes;
- a first roller (11) and a second roller (12) arranged in a position below and in a direction transversal to the first shaft (8) of the first support (6), the first roller (11) and the second roller (12) being located in, at least, one shaft (10, 16) with free rotation;
- a third roller (14) and a fourth roller (15) arranged in a position below and in a direction transversal to the second shaft (9) of the second support (7), the third roller (14) and the fourth roller (15) being located in, at least, one shaft (13, 17) with free rotation;
- a laser head (18), positioned centrally between the pair of supports (6 and 7), focused on the interface between the donor material and the donor substrate and placed at a distance from them corresponding with a focal distance of the laser head (18);
where:
- the unitary block (5) is positioned rotated an angle (21) around a Z-axis, with respect to the direction of a linear scanning (20) of the laser head (18) configured to advance according to an X-axis, the receiving substrate (4) being configured to advance according to a Y-axis, and;
- one of the shafts (8, 9) to be chosen from among the first shaft (8) and the second shaft (9) is a drive shaft;
the system being **characterized in that** the conveyor belt (1):
- runs sequentially around the first shaft (8), of the first roller (11), of the third roller (14), the second shaft (9), of the fourth roller (15), of the second roller (12) and ends in the first shaft (8) closing the conveyor belt (1), the unitary block (5) being configured in a U shape for the location, between the two supports (6, 7) and over the transfer area "A", of the laser head (18),
- rotates 90 degrees longitudinally in all the segments between the rollers (11, 12, 14, 15) and both the first shaft (8) and the second shaft (9), such that the deposition face (2) is free of contact with the elements of the system, and
- the transfer area "A" for material is defined between the location of the first roller (11) and of the third roller (14).

2. **The system for continuous laser-induced forward transfer of material,** according to claim 1, **characterized in that** the first roller (11) and the second roller (12) are located in a third shaft (10) and the third roller (14) and the fourth roller (15) are located in a fourth shaft (13).

3. **The system for continuous laser-induced forward transfer of material,** according to claim 1, **characterized in that** the first support (6) incorporates a fifth shaft (16) where the second roller (12) is located, the first roller (11) being located in the third shaft (10), while the second support (7) incorporates a sixth shaft (17) where the fourth roller (15) is located, the second roller (14) being located in the fourth shaft (13).

4. **The system for continuous laser-induced forward transfer of material,** according to claim 1, **characterized in that** the donor material is applied on the deposition face (2) as it passes continuously through the first shaft (8).

## Patentansprüche

1. System für kontinuierlichen Laser-Induced Forward Transfer (LIFT) von Material,
wobei das zu übertragende Donator-Material, das auf einem für die Laserstrahlung durchlässigen Donator-Substrat abgeschieden ist, mittels eines Laserkopfes (18), der eine Laserstrahlung emittiert, die auf die Grenzfläche zwischen dem Donator-Material und dem Donator-Substrat in einem Übertragungsbereich "A" fokussiert ist, auf ein Empfänger-Substrat (4) übertragen wird, und das Donator-Substrat ein Endlos-Förderband (1) mit einer Abscheidefläche (2) ist, auf der das Donator-Material abgeschieden wird, und umfasst:
- einen Ausschnitt, der sich in einem Aufbringungs-Bereich (3) zum Zugang zu dem Förderband (1) befindet, in dem das Donator-Material aufgebracht wird,
- einen integralen Block (5), der durch ein Paar einander zugewandter Stützen (6 und 7) gebildet wird, wobei die erste Stütze (6) und die zweite Stütze (7) jeweils tragen:
- eine erste Welle (8) und eine zweite Welle (9), die auf der gleichen Achse oder auf parallelen Achsen ausgerichtet sind;
- eine erste Rolle (11) und eine zweite Rolle (12), die an einer Position unterhalb der ersten Welle (8) der ersten Stütze (6) und in einer Richtung quer dazu angeordnet sind, wobei die erste Rolle (11) und die zweite Rolle (12) in wenigstens einer Welle (10, 16) frei drehbar angeordnet sind;
- eine dritte Rolle (14) und eine vierte Rolle (15), die an einer Position unterhalb der zweiten Welle (9) der zweiten Stütze (7) und in einer Richtung quer dazu angeordnet sind, wobei die dritte Rolle (14) und die vierte Rolle (15) in wenigstens einer Welle (13, 17) frei drehbar angeordnet sind;
- einen Laserkopf (18), der mittig zwischen den paarigen Stützen (6 und 7) positioniert ist, auf die Grenzfläche zwischen dem Donator-Material und dem Donator-Substrat fokussiert ist und in einem Abstand dazu angeordnet ist, der einer Brennweite des Laserkopfes (18) entspricht;
wobei:
- der integrale Block (5) um einen Winkel (21) um eine Z-Achse in Bezug auf die Richtung einer linearen Abtastung (20) des Laserkopfes (18) gedreht positioniert ist, der so ausgeführt ist, dass er sich entsprechend einer X-Achse vorwärts bewegt, wobei das Empfänger-Substrat (4) so ausgeführt ist, dass es sich entsprechend einer Y-Achse vorwärts bewegt, und
- eine der Wellen (8, 9), die aus der ersten Welle (8) und der zweiten Welle (9) ausgewählt wird, eine Antriebswelle ist;
wobei das System **dadurch gekennzeichnet ist, dass** das Förderband (1):
- sequentiell um die erste Welle (8) der ersten Rolle (11), der dritten Rolle (14), die zweite Welle (9) der vierten Rolle (15), der zweiten Rolle (12) herum läuft und in der ersten Welle (8) endet und das Förderband (1) schließt, wobei der integrale Block (5) in einer U-Form für die Anordnung des Laserkopfes (18) zwischen den zwei Stützen (6, 7) und über den Übertragungsbereich "A" ausgeführt ist,
- sich um 90° in Längsrichtung in allen Segmenten zwischen den Rollen (11, 12, 14, 15) und sowohl der ersten Welle (8) als auch der zweiten Welle (9) so dreht, dass die Abscheidefläche (2) frei von Kontakt mit den Elementen des Systems ist, und
- der Übertragungsbereich "A" für Material zwischen der Position der ersten Rolle (11) und der dritten Rolle (14) ausgebildet ist.

2. System für kontinuierlichen Laser-Induced Forward Transfer von Material nach Anspruch 1, **dadurch gekennzeichnet, dass** die erste Rolle (11) und die zweite Rolle (12) in einer dritten Welle (10) angeordnet sind und die dritte Rolle (14) und die vierte Rolle (15) in einer vierten Welle (13) angeordnet sind.

3. System für kontinuierlichen Laser-Induced Forward Transfer von Material nach Anspruch 1, **dadurch gekennzeichnet, dass** die erste Stütze (6) eine fünfte Welle (16) enthält, an der die zweite Rolle (12) angeordnet ist, wobei die erste Rolle (11) in der dritten Welle (10) angeordnet ist, während die zweite Stütze (7) eine sechste Welle (17) enthält, an der die vierte Rolle (15) angeordnet ist, und die zweite Rolle (14) in der vierten Welle (13) angeordnet ist.

4. System für kontinuierlichen Laser-Induced Forward Transfer von Material nach Anspruch 1, **dadurch gekennzeichnet, dass** das Donator-Material auf die Abscheidefläche (2) aufgebracht wird, während sie kontinuierlich über die erste Welle (8) läuft.

## Revendications

1. Système pour le transfert avant de matériau induit par laser continu, dans lequel le matériau donneur à transférer, déposé sur un substrat donneur, transparent au rayonnement laser, est transféré sur un substrat de réception (4) au moyen d'une tête laser (18) qui émet un rayonnement laser concentré sur l'interface entre le matériau donneur et le substrat donneur dans une zone de transfert « A », dans lequel le substrat donneur est une courroie transporteuse continue (1) avec une face de dépôt (2) où le matériau donneur est déposé et comprend :
- une mortaise positionnée dans une zone d'application (3) pour l'accès à la courroie transporteuse (1), où le matériau donneur est appliqué,
- un bloc unitaire (5) défini par une paire de supports (6 et 7) se faisant face, le premier support (6) et le second support (7) étant respectivement des supports de :
- un premier arbre (8) et un deuxième arbre (9), alignés sur un même axe ou sur des axes parallèles ;
- un premier rouleau (11) et un deuxième rouleau (12) agencés dans une position au-dessous du et dans une direction transversale au premier arbre (8) du premier support (6), le premier rouleau (11) et le deuxième rouleau (12) étant positionnés, au moins dans un arbre (10, 16) avec une rotation libre ;
- un troisième rouleau (14) et un quatrième rouleau (15) agencés dans une position au-dessous du et dans une direction transversale au deuxième arbre (9) du second support (7), le troisième rouleau (14) et le quatrième rouleau (15) étant positionnés, au moins dans un arbre (13, 17) avec une rotation libre ;
- une tête laser (18) positionnée de manière centrale entre la paire de supports (6 et 7), concentrée sur l'interface entre le matériau donneur et le substrat donneur et placée à une certaine distance de ces derniers correspondant à une distance focale de la tête laser (18) ;
dans lequel :
- le bloc unitaire (5) est entraîné en rotation selon un angle (21) autour d'un axe Z, par rapport à la direction d'un balayage linéaire (20) de la tête laser (18) configurée pour avancer selon un axe X, le substrat de réception (4) étant configuré pour avancer selon un axe Y ; et
- l'un des arbres (8, 9) à choisir parmi le premier arbre (8) et le deuxième arbre (9) est un arbre d'entraînement ;
le système étant **caractérisé en ce que** la courroie transporteuse (1) :
- s'étend de manière séquentielle autour du premier arbre (8), du premier rouleau (11), du troisième rouleau (14), du deuxième arbre (9), du quatrième rouleau (15), du deuxième rouleau (12) et se termine par le premier arbre (8) qui ferme la courroie transporteuse (1), le bloc unitaire (5) étant configuré en forme de U pour l'emplacement, entre les deux supports (6, 7) et sur la surface de transfert « A » de la tête laser (18),
- tourne à 90 degrés longitudinalement dans tous les segments entre les rouleaux (11, 12, 14, 15) et à la fois le premier arbre (8) et le deuxième arbre (9), de sorte que la face de dépôt (2) est dépourvue de contact avec les éléments du système, et
- la zone de transfert « A » pour le matériau est définie entre l'emplacement du premier rouleau (11) et du troisième rouleau (14).

2. Système pour le transfert avant de matériau induit par laser continu selon la revendication 1, **caractérisé en ce que** le premier rouleau (11) et le deuxième rouleau (12) sont positionnés dans un troisième arbre (10) et le troisième rouleau (14) et le quatrième rouleau (15) sont positionnés dans un quatrième arbre (13).

3. Système pour le transfert avant de matériau induit par laser continu selon la revendication 1, **caractérisé en ce que** le premier support (6) comprend un cinquième arbre (16) où le deuxième rouleau (12) est positionné, le premier rouleau (11) étant positionné dans le troisième arbre (10), alors que le second support (7) comprend un sixième arbre (17) où le quatrième rouleau (15) est positionné, le deuxième rouleau (14) étant positionné dans le quatrième arbre (13).

4. Système pour le transfert avant de matériau induit par laser continu selon la revendication 1, **caractérisé en ce que** le matériau donneur est appliqué sur la face de dépôt (2) lorsqu'il passe de manière continue à travers le premier arbre (8).
